# EUROPEAN PATENT APPLICATION

(11) **EP 4 692 561 A1**
(43) Date of publication of application: **11.02.2026**
(21) Application number: 24780108.7
(22) Date of filing: 25.03.2024
(51) Int. Cl.: F04D 19/04

(54) **VACUUM PUMP, CONTROL DEVICE, AND TEMPERATURE RISING TIME CONTROL METHOD**

(30) Priority: 29.03.2023 JP 2023054227
(71) Applicant: Edwards Japan Limited, Yachiyo-shi, Chiba 276-8523 (JP)
(72) Inventor: HONMA, Ryutaro, Yachiyo-shi Chiba 276-8523 (JP); SAKAGUCHI, Yoshiyuki, Yachiyo-shi Chiba 276-8523 (JP)
(74) Representative: Openshaw & Co.
(86) International application number: PCT/JP2024/011556
(87) International publication number: WO 2024/203990

(57) **Abstract**

To provide a vacuum pump, a control device, and a warmup time control method by which warmup time of the pump can be reduced while protecting a board from high temperatures involved with heating. Temperature information is detected from a temperature sensor 3 that is situated near a heater 1, and is input to a control device 200. Determination of a warmup state is started in step 1 by a warmup state determining unit of the control device 200. Temperature information that is input is compared with a rated temperature in step 3. This rated temperature differs depending on the model and specifications of the pump, but is defined as a target temperature necessary to prevent depositing of product matter. Judgment is made of a post-warmup mode when all temperature information that is input is higher than the rated temperature as shown in step 5, and in step 9 this processing is completed. Conversely, when in a state that is lower than the rated temperature, judgment is made of a warmup-underway mode, as shown in step 7, and in step 9 this processing is completed. Thereafter, operations of step 1 to step 9 are periodically repeated.

## Description

The present invention relates to a vacuum pump, a control device, and a warmup time control method, and more particularly relates to a vacuum pump, a control device, and a warmup time control method by which warmup time of the pump can be reduced while protecting boards from high temperatures involved with heating.

Advance in electronics in recent years is leading to rapid increase in demand for semiconductors such as memory, integrated circuits, and so forth.

These semiconductors are fabricated by doping extremely highly pure semiconductor substrates with impurities to impart electrical properties, forming minute circuits on the semiconductor substrates by etching, and so forth.

Such work needs to be performed in a chamber in a high-vacuum state to avoid being affected by dust and the like in air. Vacuum pumps are generally used for exhausting the chamber, and turbomolecular pumps in particular, which are a type of vacuum pump, are widely used from the perspectives of having little residual gas, ease of maintenance, and so forth.

Also, manufacturing processes of semiconductors include many processes in which various types of process gasses act upon the semiconductor substrates. Turbomolecular pumps are used not only to draw the inside of the chamber to a vacuum, but also to exhaust such process gasses from the inside of the chamber.

Now, there are cases in which process gasses are introduced into the chamber in a high-temperature state, in order to increase reactivity.

Now, there are cases in which these process gasses become cooled when exhausted and become solids at a certain temperature, and precipitation of product matter in an exhaust system occurs. There are cases in which such types of process gasses cool and reach a solid state inside the turbomolecular pump, and adhere to and become deposited inside of the turbomolecular pump.

When such deposition of precipitates of process gasses inside of the turbomolecular pump occurs, this deposited matter narrows the pump channels and becomes a cause of lowered performance of the turbomolecular pump.

In order to solve this problem, conventionally, heaters and annular water-cooling tubes are wound on a pump outer circumference of the turbomolecular pump and a temperature sensor is embedded near the heater for example, and heating of the heater is performed on the basis of signals from this temperature sensor so as to maintain temperature around the heater at a high temperature within a certain range (see PTL 1). This temperature is preferably set as high as possible, since the higher this control temperature is, the less readily product matter is deposited.

However, printed circuit boards on which semiconductor devices and so forth are mounted are situated in electrical component portions. There is a concern that the temperature of the printed circuit boards may exceed a limit temperature of the semiconductor devices when a base portion is heated to high temperatures. Accordingly, coolant water is normally made to constantly flow through the water-cooling tubes from the perspective of safety, so that the temperature of the electrical component portions containing the printed circuit boards does not exceed the limit temperature of the semiconductor devices.

[PTL 1] Japanese Patent Application Publication No. 2005-315090

However, the above-described temperature control cannot meet all of the demands such as the following (1) to (3) .
(1) To constantly perform water cooling of the base portion in order to prevent malfunctioning or failure of the printed circuit boards due to high temperature.
(2) To stop water cooling of the base portion during warmup, in order to realize reduction in warmup time.
(3) To start water cooling in order to perform cooling in a case in which the limit temperature of the semiconductor devices is exceeded during warmup.

Now, for (1), this can be realized by constantly performing water cooling without a controller intervening, and in a case of realizing both (1) and (2), constantly keeping a valve for a water-cooling tube (water-cooling valve) open under normal conditions is sufficient, but there is need to stop in a certain section (warmup-underway).

In a case of attempting to control this with a controller, on and off operations will be performed between an upper limit temperature and a lower limit temperature in the above-described temperature control, in order to maintain a target temperature around the heater. Accordingly, control that satisfies all of (1) to (3) cannot be performed.

The present invention has been made in light of such conventional problems, and it is an object thereof to provide a vacuum pump, a control device, and a warmup time control method by which warmup time of the pump can be reduced while protecting the boards from high temperatures involved with heating.

Accordingly, a vacuum pump according to the present invention (claim 1) includes a heating unit with a heater situated in at least one place to prevent generation of deposited matter, a base portion in which a cooling mechanism is situated to prevent temperature within an electrical component portion from becoming high base portion temperature measuring means for measuring temperature of the base portion, a water-cooling valve for controlling whether or not to perform cooling by the cooling mechanism, and temperature judging means for judging whether post-warmup or warmup-underway, in accordance with whether or not temperatures of all of the heaters of the heating unit exceed a set temperature that is set in advance. The water-cooling valve is controlled on the basis of judgment results by the temperature judging means and the temperatures measured by the base portion temperature measuring means.

Whether post-warmup or warmup-underway is judged in accordance with whether or not temperatures of all of the heaters situated in the heating unit exceed the set temperature that is set in advance. The water-cooling valve is then controlled on the basis of these results of judgment and the temperatures measured at the base portion.

Accordingly, reduction in warmup time of the pump can be realized while safely protecting the semiconductor devices.

Also, in the vacuum pump according to the present invention (claim 2), cooling by the cooling mechanism is not performed when judgment of warmup-underway is made by the temperature judging means, and the temperature measured by the base portion temperature measuring means is no greater than a temperature lower limit value for cooling.

Accordingly, reduction of warmup time of the pump during warmup-underway can be realized.

Further, in the vacuum pump according to the present invention (claim 3), cooling by the cooling mechanism is performed when the temperature measured by the base portion temperature measuring means is no lower than a temperature upper limit value for cooling.

Performing cooling control on the basis of the temperature measured at the base portion around electrical component portions enables temperature management of the electrical component portions to be appropriately performed.

Further, in the vacuum pump according to the present invention (claim 4), the temperature upper limit value for cooling is a limit temperature value at which a board situated in the electrical component portion can be protected, or a temperature value set allowing for a certain amount of leeway with respect to the limit temperature value.

Accordingly, in a case in which the limit temperature of the semiconductor devices is exceeded, cooling is performed by the cooling mechanism, and accordingly malfunctioning or failure of the semiconductor devices due to high temperatures can be prevented, and safety can be realized.

Further, in the vacuum pump according to the present invention (claim 5), cooling by the cooling mechanism is performed when judgment of post-warmup is made by the temperature judging means.

At the point in time of completing warmup, the water-cooling valve is in a constantly open state. Accordingly, the boards can be protected from high temperatures involved with heating.

The vacuum pump according to the present invention (claim 6) further includes heating unit temperature measuring means for measuring a temperature of the heating unit. The set temperature has a temperature lower limit value for heating and a temperature upper limit value for heating, heating by the heater is performed when the temperature measured by the heating unit temperature measuring means is no greater than the temperature lower limit value for heating, and heating by the heater is stopped when the temperature measured by the heating unit temperature measuring means is no lower than the temperature upper limit value for heating.

Accordingly, high temperature can be maintained at parts other than the base portion, and deposition of product matter can be stably prevented.

Further, in the vacuum pump according to the present invention (claim 7), a heating region heated by the heating unit and a cooling region of the base portion including the electrical component portion are thermally partitioned.

Accordingly, conduction of heat to the regions of each other can be prevented, and thus reduction in warmup time of the pump can be realized while safely protecting the semiconductor devices in an even more sure manner.

Further, the present invention (claim 8) is a control device of a vacuum pump that includes a heating unit with a heater situated in at least one place to prevent generation of deposited matter, a base portion in which a cooling mechanism is situated to prevent temperature within an electrical component portion from becoming high, base portion temperature measuring means for measuring temperature of the base portion, and a water-cooling valve for controlling whether or not to perform cooling by the cooling mechanism. The control device includes temperature judging means for judging whether post-warmup or warmup-underway, in accordance with whether or not temperatures of all of the heaters of the heating unit exceed a set temperature that is set in advance. The water-cooling valve is controlled on the basis of judgment results by the temperature judging means and the temperatures measured by the base portion temperature measuring means.

Further, the present invention (claim 9) is a control method of warmup time of a vacuum pump that includes a heating unit with a heater situated in at least one place to prevent generation of deposited matter, a base portion in which a cooling mechanism is situated to prevent temperature within an electrical component portion from becoming high, base portion temperature measuring means for measuring temperature of the base portion, and a water-cooling valve for controlling whether or not to perform cooling by the cooling mechanism. The control method includes judging whether post-warmup or warmup-underway, in accordance with whether or not temperatures of all of the heaters of the heating unit exceed a set temperature that is set in advance, and controlling the water-cooling valve on the basis of the temperatures measured by the base portion temperature measuring means, when judgment is made of warmup-underway.

According to the present invention (claim 1), as described above, a configuration is made in which temperature judging means is provided for judging whether post-warmup or warmup-underway, in accordance with whether or not temperatures of all of the heaters of the heating unit exceed a set temperature that is set in advance, and the water-cooling valve is controlled on the basis of judgment results by the temperature judging means and the temperatures measured by the base portion temperature measuring means, and thus reduction in warmup time of the pump can be realized while safely protecting the semiconductor devices.

[Fig. 1]

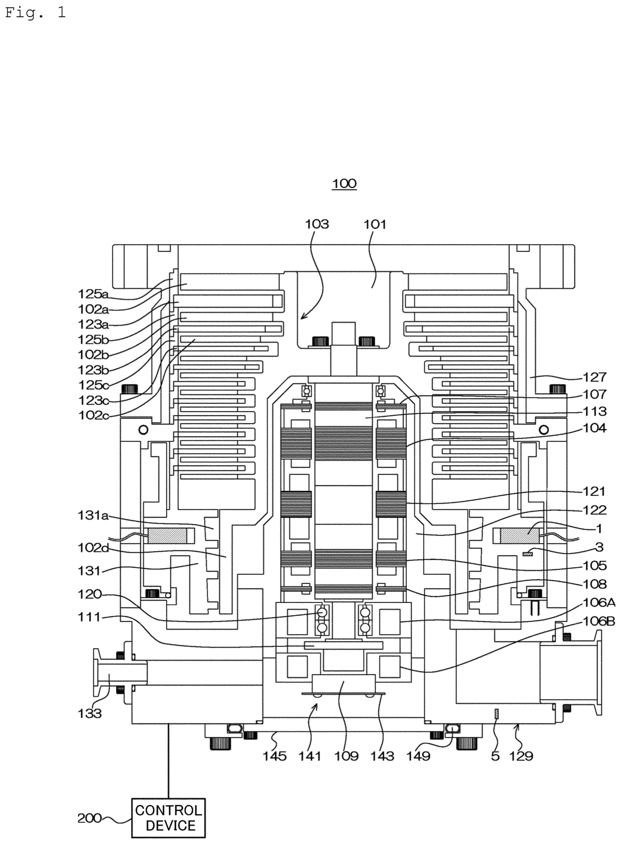

   Fig. 1 is a configuration diagram illustrating a turbomolecular pump that is an embodiment of the present invention.
[Fig. 2]

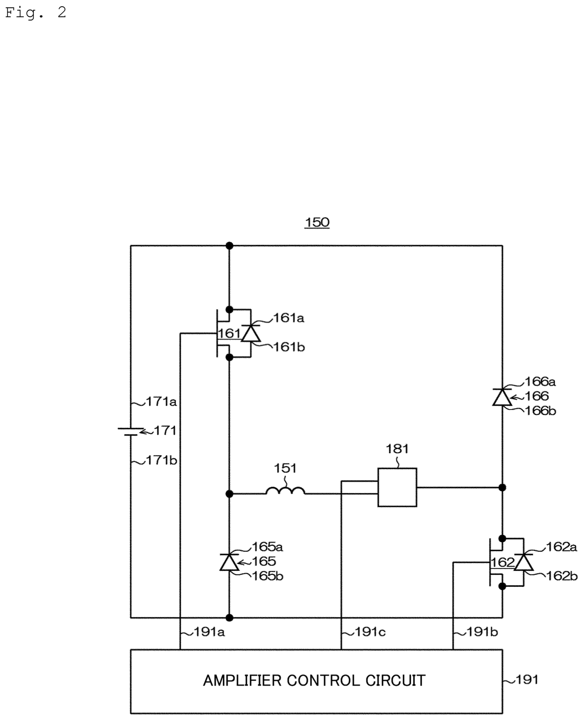

   Fig. 2 is a circuit diagram of an amplifier circuit.
[Fig. 3]

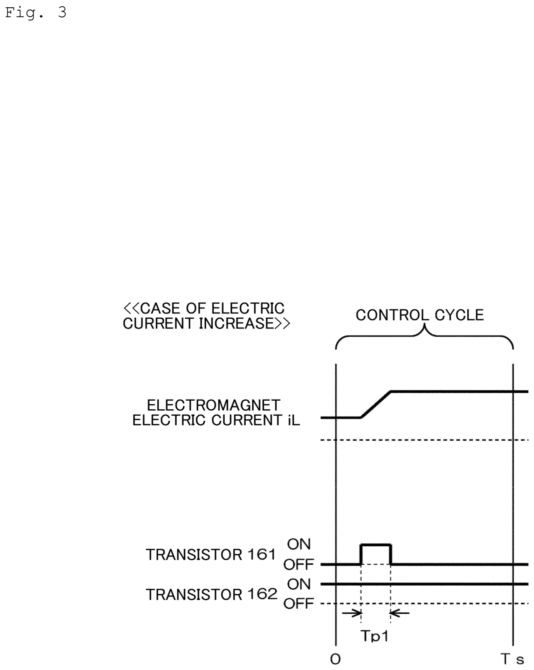

   Fig. 3 is a timing chart showing control in a case in which an electric current command value is greater than a detection value.
[Fig. 4]

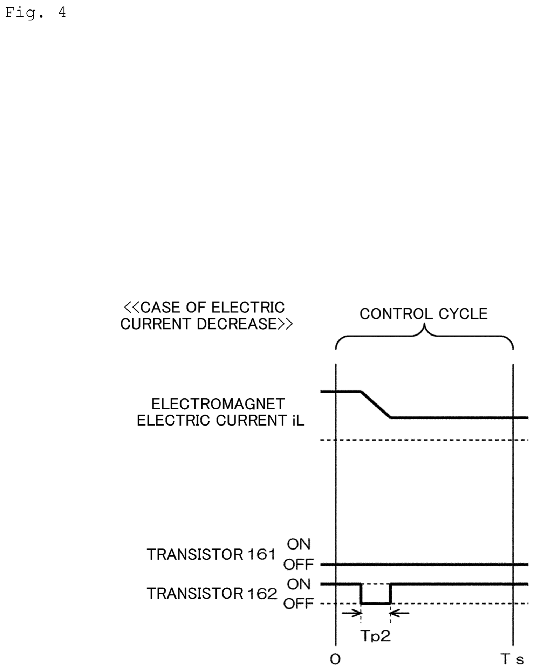

   Fig. 4 is a timing chart showing control in a case in which the electric current command value is smaller than the detection value.
[Fig. 5]

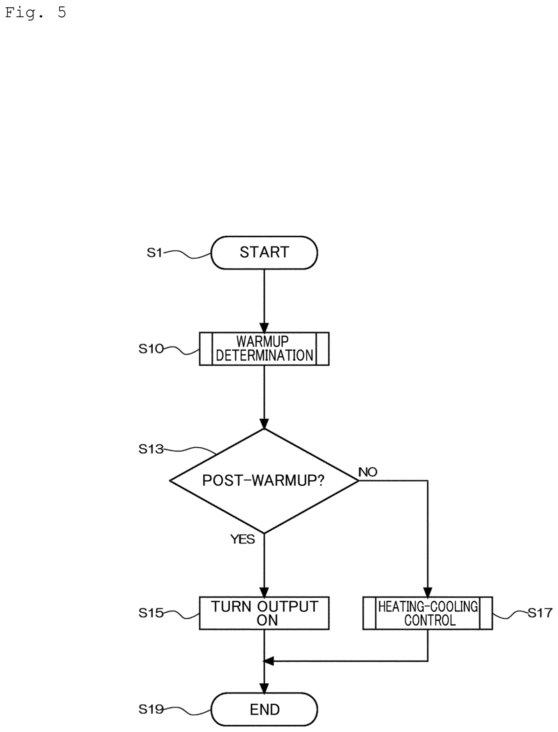

   Fig. 5 is a diagram for describing operations of a temperature control unit of a base portion.
[Fig. 6]

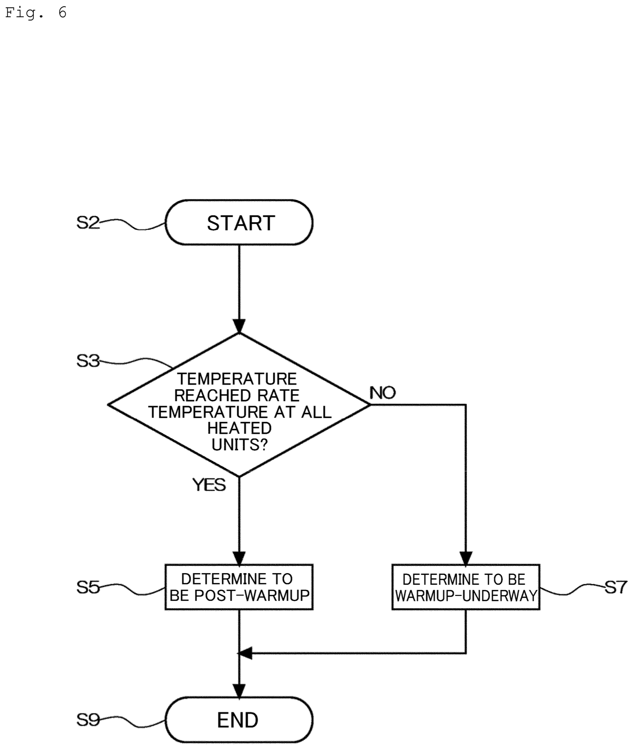

   Fig. 6 is a diagram for describing operations of a warmup state determining unit.
[Fig. 7]

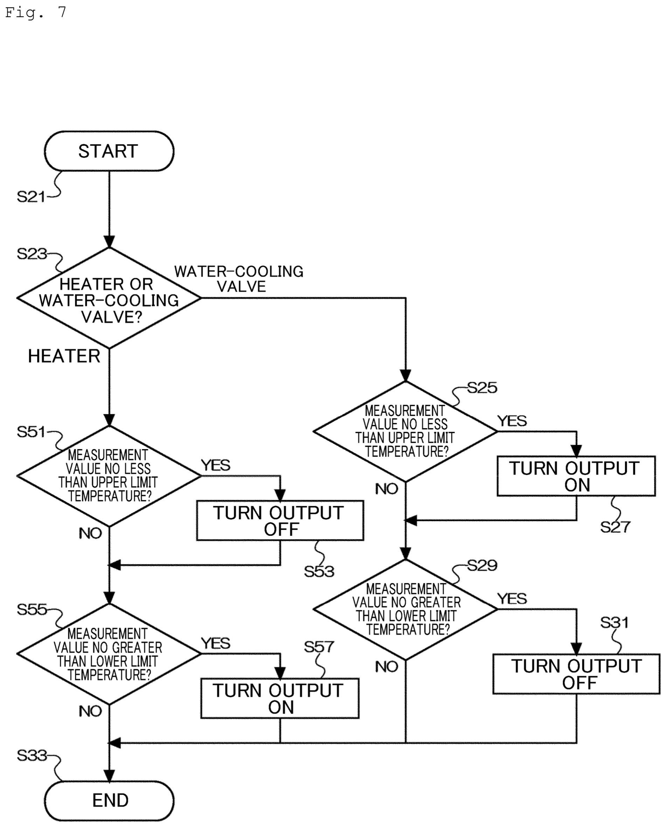

   Fig. 7 is a diagram for describing operations of a heating-cooling control unit.
[Fig. 8]

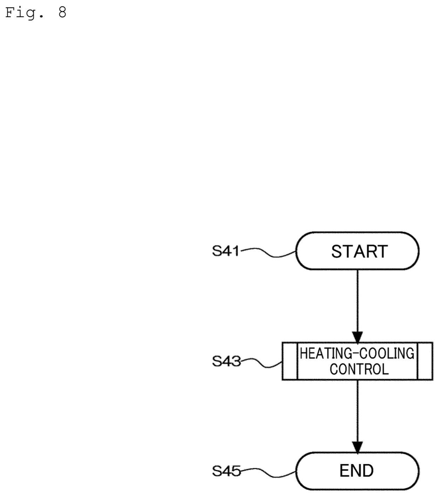

   Fig. 8 is a diagram for describing temperature control regarding parts other than the base portion.

Next, an embodiment of the present invention will be described. Fig. 1 is a longitudinal sectional view of this turbomolecular pump 100. In Fig. 1, an inlet port 101 is formed at an upper end of an outer cylinder 127, which is cylindrically shaped, in the turbomolecular pump 100. Provided on the inner side of the outer cylinder 127 is a rotating body 103, on a peripheral portion of which a plurality of rotor blades 102 (102a, 102b, 102c ...) serving as turbine blades for suctioning and exhausting gas are formed radially and in a plurality of stages. A rotor shaft 113 is attached to a center of the rotating body 103, and the rotor shaft 113 is made to be supported by levitation in air and to be position-controlled by a five-axis control magnetic bearing, for example. The rotating body 103 is generally made of a metal such as aluminum, aluminum alloy, or the like.

Upper-side radial-direction electromagnets 104 are four electromagnets, situated in pairs on an X axis and a Y axis. Four upper-side radial-direction sensors 107 are provided in close proximity to the upper-side radial-direction electromagnets 104 and corresponding to each of the upper-side radial-direction electromagnets 104. Inductance sensors, eddy current sensors, or the like, having conducting windings, are used as the upper-side radial-direction sensors 107, for example. A position of the rotor shaft 113 is detected on the basis of change in inductance of the conducting windings that changes in accordance with the position of the rotor shaft 113. These upper-side radial-direction sensors 107 are configured to detect radial-direction displacement of the rotor shaft 113, i.e., of the rotating body 103 fixed thereto, and to send this to a control device 200.

In this control device 200, a compensating circuit having PID adjusting functions, for example, generates excitation control command signals for the upper-side radial-direction electromagnets 104 on the basis of position signals detected by the upper-side radial-direction sensors 107, and an amplifier circuit 150 (described later) illustrated in Fig. 2 performs excitation control of the upper-side radial-direction electromagnets 104 on the basis of these excitation control command signals, thereby adjusting a radial-direction position of an upper side of the rotor shaft 113.

This rotor shaft 113 is formed of a material having high magnetic permeability (iron, stainless steel, etc.) or the like, and is arranged to be attracted by magnetic force of the upper-side radial-direction electromagnets 104. This adjustment is performed independently for each of an X-axial direction and a Y-axial direction. Lower-side radial-direction electromagnets 105 and lower-side radial-direction sensors 108 are also situated in the same way as the upper-side radial-direction electromagnets 104 and the upper-side radial-direction sensors 107, and adjust a radial-direction position of a lower side of the rotor shaft 113 in the same way as with the radial-direction position of the upper side.

Further, axial-direction electromagnets 106A and 106B are situated across a metal disc 111 that is disc-shaped and is provided at a lower portion of the rotor shaft 113, from above and below. The metal disc 111 is made of a high magnetic permeability material such as iron or the like. An axial-direction sensor 109 is provided in order to detect displacement of the rotor shaft 113 in an axial direction thereof, and is configured to send axial-direction position signals thereof to the control device 200.

In the control device 200, the compensating circuit having PID controller functions, for example, generates excitation control command signals for each of the axial-direction electromagnet 106A and the axial-direction electromagnet 106B on the basis of the axial-direction position signals detected by the axial-direction sensor 109, and the amplifier circuit 150 performs excitation control of each of the axial-direction electromagnet 106A and the axial-direction electromagnet 106B on the basis of these excitation control command signals, whereby the axial-direction electromagnet 106A attracts the metal disc 111 upward by magnetic force and the axial-direction electromagnet 106B attracts the metal disc 111 downward, thereby adjusting the axial-direction position of the rotor shaft 113.

Thus, the control device 200 is arranged to adjust the magnetic force that the axial-direction electromagnets 106A and 106B apply to the metal disc 111 as appropriate, causing magnetic levitation of the rotor shaft 113 in the axial direction, so as to be held in air without contact. Note that the amplifier circuit 150 that performs excitation control of the upper-side radial-direction electromagnets 104, the lower-side radial-direction electromagnets 105, and the axial-direction electromagnets 106A and 106B, will be described later.

Also, a motor 121 is provided with a plurality of magnetic poles situated perimetrically surrounding the rotor shaft 113. Each magnetic pole is controlled by the control device 200 so as to rotationally drive the rotor shaft 113 through electromagnetic force acting between itself and the rotor shaft 113. An unshown rotational velocity sensor, such a Hall device, a resolver, an encoder, or the like, for example, is assembled into the motor 121, and an arrangement is made in which rotational velocity of the rotor shaft 113 is detected by detection signals from this rotational velocity sensor.

Further, an unshown phase sensor is attached in a proximity of the lower-side radial-direction sensors 108 for example, and is arranged to detect a phase of rotation of the rotor shaft 113. The control device 200 is arranged to use both of detection signals of this phase sensor and the rotational velocity sensor to detect the position of the magnetic poles.

A plurality of stator blades 123 (123a, 123b, 123c ...) are disposed with a slight spacing as to the rotor blades 102 (102a, 102b, 102c ...). The rotor blades 102 (102a, 102b, 102c ...) are each formed inclined at a predetermined angle from a plane perpendicular to an axial line of the rotor shaft 113, in order to transport molecules of exhaust gas downward through collision therewith. The stator blades 123 (123a, 123b, 123c ...) are made of a metal such as, for example, aluminum, iron, stainless steel, copper, or the like, or a metal such as an alloy containing these metals as a component.

The stator blades 123 are also formed inclined at a predetermined angle from the plane perpendicular to the axial line of the rotor shaft 113 in the same way, and are disposed extending toward the inner side of the outer cylinder 127, alternating with the stages of the rotor blades 102. Outer circumferential ends of the stator blades 123 are supported in a state of being inserted between a plurality of stator blade spacers 125 (125a, 125b, 125c ...) that are stacked up.

The stator blade spacers 125 are ring-shaped members, and are made of a metal such as, for example, aluminum, iron, stainless steel, copper, or the like, or a metal such as an alloy containing these metals as a component. The outer cylinder 127 is fixed on outer circumferences of the stator blade spacers 125, with a slight gap therebetween. A base portion 129 is disposed at a bottom portion of the outer cylinder 127. An outlet port 133 is formed in the base portion 129 so as to externally communicate. Exhaust gas that enters the inlet port 101 from a chamber (a vacuum chamber) side and is transported to the base portion 129 is sent to the outlet port 133.

Further, depending on the use of the turbomolecular pump 100, a thread-attachment spacer 131 is disposed between a bottom portion of the stator blade spacers 125 and the base portion 129. The thread-attachment spacer 131 is a cylindrically shaped member made of aluminum, copper, stainless steel, or iron, a metal such as an alloy containing these metals as a component, or the like, with a plurality of thread grooves 131a that are spiral-like and that are cut in an inner circumferential face thereof. A direction of spiraling of the thread grooves 131a is a direction in which molecules of exhaust gas are transported toward the outlet port 133, when the molecules move in a rotational direction of the rotating body 103. A cylindrical portion 102d that extends downward continuing from the rotor blades 102 (102a, 102b, 102c ...) is provided at a bottommost portion of the rotating body 103. An outer circumferential face of this cylindrical portion 102d is cylindrically shaped and is enlarged toward the inner circumferential face of the thread-attachment spacer 131, and is in close proximity with the inner circumferential face of the thread-attachment spacer 131 across a predetermined gap. The exhaust gas transported to the thread grooves 131a by the rotor blades 102 and the stator blades 123 is sent to the base portion 129, while being guided by the thread grooves 131a.

The base portion 129 is a disc-shaped member making up a base portion of the turbomolecular pump 100, and generally is made of a metal such as iron, aluminum, stainless steel, or the like. The base portion 129 serves to physically hold the turbomolecular pump 100, and also has functions of a thermal conduction path, and accordingly a metal that has rigidity, and also has high thermal conductivity, such as iron, aluminum, copper, or the like, is preferably used.

In this configuration, upon the rotor blades 102 being rotationally driven by the motor 121 along with the rotor shaft 113, exhaust gas is sucked through the inlet port 101 from the chamber, by operations of the rotor blades 102 and the stator blades 123. The rotational velocity of the rotor blades 102 normally is 20000 rpm to 90000 rpm, and peripheral velocity at tip ends of the rotor blades 102 reaches 200 m/s to 400 m/s. Exhaust gas sucked through the inlet port 101 passes between the rotor blades 102 and the stator blades 123, and is transported to the base portion 129. At this time, the temperature of the rotor blades 102 rises due to frictional heat generated by the exhaust gas coming into contact with the rotor blades 102, conduction of heat generated at the motor 121, and so forth, but this heat is conveyed to the stator blades 123 side by radiation, and by conduction by gas molecules of the exhaust gas and so forth.

The stator blade spacers 125 are in contact with each other at outer circumferential portions thereof, and externally convey the heat that the stator blades 123 receive from the rotor blades 102, the frictional heat generated at the time of the exhaust gas coming into contact with the stator blades 123, and so forth.

Note that description has been made above that the thread-attachment spacer 131 is disposed on an outer circumference of the cylindrical portion 102d of the rotating body 103, with the thread grooves 131a cut in the inner circumferential face of the thread-attachment spacer 131. However, there are reverse cases in which thread grooves are cut in the outer circumferential face of the cylindrical portion 102d, and a spacer having a cylindrically shaped inner circumferential face is situated therearound.

Also, depending on the use of the turbomolecular pump 100, there are cases in which a perimeter of electrical component portions made up of the upper-side radial-direction electromagnets 104, the upper-side radial-direction sensors 107, the motor 121, the lower-side radial-direction electromagnets 105, the lower-side radial-direction sensors 108, the axial-direction electromagnets 106A and 106B, the axial-direction sensor 109, and so forth, is covered by a stator column 122, so that gas suctioned through the inlet port 101 does not intrude into the electrical component portion, and inside of this stator column 122 is maintained at a predetermined pressure by a purge gas.

In this case, unshown piping is disposed in the base portion 129, and the purge gas is introduced through this piping. The introduced purge gas is sent out to the outlet port 133 through gaps between a protective bearing 120 and the rotor shaft 113, between a rotor and a stator of the motor 121, and between the stator column 122 and inner-circumferential-side cylindrical portions of the rotor blades 102.

Now, the turbomolecular pump 100 requires control based on identification of model, and individually-adjusted unique parameters (e.g., various characteristics corresponding to the model). The turbomolecular pump 100 is provided with an electronic circuit portion 141 within a main unit thereof, in order to store these control parameters. The electronic circuit portion 141 is made up of electronic parts such as semiconductor memory such as EEP-ROM or the like, semiconductor devices for access thereto and so forth, a board 143 for mounting of these, and so forth. The electronic circuit portion 141 is accommodated below an unshown rotational velocity sensor near a middle, for example, of the base portion 129 that makes up a lower portion of the turbomolecular pump 100, and is closed off by a bottom cover 145 that is airtight.

Now, there are some process gasses introduced into the chamber during manufacturing processes of semiconductors that have a nature of solidifying when a pressure thereof becomes higher than a predetermined value or a temperature thereof becoming lower than a predetermined value. Inside of the turbomolecular pump 100, the pressure of exhaust gas is lowest at the inlet port 101 and is highest at the outlet port 133. When the pressure of the process gas becomes higher than the predetermined value, or the temperature thereof becomes lower than the predetermined value, while being transported from the inlet port 101 to the outlet port 133, the process gas solidifies, adheres to the inside of the turbomolecular pump 100, and is deposited.

For example, in a case of using SiCl₄ as a process gas in an Al etching device, it can be understood from a vapor pressure curve that precipitation of solid product matter (e.g., AlCl₃) will occur under low vacuum (760 [torr] to 10⁻² [torr]) and low temperature (approximately 20[°C]), and become adhered to and deposited on the inside of the turbomolecular pump 100. Accordingly, when deposition of a precipitate of a process gas on the inside of the turbomolecular pump 100 occurs, the deposited matter narrows pump channels, which causes deterioration in performance of the turbomolecular pump 100. In such a situation, the aforementioned product matter has tended to solidify and adhere at portions where pressure is high, such as near the outlet port 133 and near the thread-attachment spacer 131.

Accordingly, in order to solve this problem, an arrangement is made in which a heater 1, and a water-cooling tube 149 that is annular in shape, are wound onto an outer circumference of the base portion 129 or the like, and also a temperature sensor 3 (e.g., a thermistor) is embedded near to the heater 1, for example. Heating by the heater 1 and cooling by the water-cooling tube 149 so as to maintain the temperature of the base portion 129 at a constant high temperature (set temperature) on the basis of signals from this temperature sensor 3 are performed (hereinafter referred to as TMS. TMS; Temperature Management System). An unshown water-cooling valve is situated on the water-cooling tube 149, in order to control cooling.

Note, however, that in order to raise the efficiency of TMS, an unshown heater may be further situated in the outlet port 133, and also an unshown temperature sensor may be situated near this heater. Note that a temperature sensor 5 is situated in the base portion 129 near the water-cooling tube 149, in order to control cooling.

A heating region that is formed around a heating unit such as the heater 1 and the heater situated in the outlet port 133, and a cooling region of the base portion 129 including electrical component portions are structurally separated, and accordingly are thermally partitioned. Accordingly, conduction of heat to the regions of each other can be prevented, and thus reduction in warmup time of the pump can be realized while safely protecting the semiconductor devices in an even more sure manner.

Next, with respect to the turbomolecular pump 100 configured thus, the amplifier circuit 150 that performs excitation control of the upper-side radial-direction electromagnets 104, the lower-side radial-direction electromagnets 105, and the axial-direction electromagnets 106A and 106B will be described. A circuit diagram of this amplifier circuit 150 is illustrated in Fig. 2.

In Fig. 2, an electromagnet winding 151 that makes up the upper-side radial-direction electromagnets 104 and so forth is connected on one end thereof to a positive terminal 171a of an electric power source 171 via a transistor 161, and connected on the other end thereof to a negative terminal 171b of the electric power source 171 via an electric current detecting circuit 181 and a transistor 162. The transistors 161 and 162 are so-called power MOSFETs, having a structure in which a diode is connected between a source and a drain thereof.

At this time, the transistor 161 is arranged such that a cathode terminal 161a of the diode thereof is connected to the positive terminal 171a, and also an anode terminal 161b is connected to one end of the electromagnet winding 151. Also, the transistor 162 is arranged such that a cathode terminal 162a of the diode thereof is connected to the electric current detecting circuit 181, and also an anode terminal 162b is connected to the negative terminal 171b.

Meanwhile, a diode 165 for electric current regeneration is arranged such that a cathode terminal 165a thereof is connected to the one end of the electromagnet winding 151, and also an anode terminal 165b thereof is connected to the negative terminal 171b. In the same way, a diode 166 for electric current regeneration is arranged such that a cathode terminal 166a thereof is connected to the positive terminal 171a, and also an anode terminal 166b thereof is connected to the other end of the electromagnet winding 151 via the electric current detecting circuit 181. The electric current detecting circuit 181 is made up of a Hall sensor type electric current sensor or an electric resistive element, for example.

The amplifier circuit 150 that is configured as described above corresponds to one electromagnet. Accordingly, in a case in which the magnetic bearing is of five-axis control, and there is a total of ten electromagnets 104, 105, 106A, and 106B, an arrangement is made in which the same amplifier circuit 150 is configured for each of the electromagnets, and ten amplifier circuits 150 are connected in parallel as to the electric power source 171.

Further, an amplifier control circuit 191 is made up of, for example, an unshown digital signal processor unit (hereinafter referred to as DSP unit) of the control device 200, and this amplifier control circuit 191 is arranged to switch on/off of the transistors 161 and 162.

The amplifier control circuit 191 is arranged to compare an electric current value detected by the electric current detecting circuit 181 (a signal that reflects this electric current value will be referred to as electric current detection signal 191c) with a predetermined electric current command value. An arrangement is made in which magnitudes of pulse widths (pulse-width durations Tp1 and Tp2) to be generated within a control cycle Ts, which is one cycle by PWM control, are determined on the basis of the comparison results thereof. Consequently, an arrangement is made in which gate driving signals 191a and 191b that have these pulse widths are output from the amplifier control circuit 191 to gate terminals of the transistors 161 and 162.

Note that at the time of passing a resonance point while performing operations to accelerate the rotational velocity of the rotating body 103, or in a case in which external disturbance occurs during constant speed operation or the like, positional control of the rotating body 103 needs to be performed with a fast and strong force. Accordingly, the power source 171 is arranged to use a voltage of around 50 V, for example, so as to be capable of abrupt increase (or decrease) of electric current flowing through the electromagnet winding 151. Also, a capacitor (omitted from illustration) is usually connected between the positive terminal 171a and the negative terminal 171b of the power source 171, for stabilization of the electric power source 171.

In this configuration, when both of the transistors 161 and 162 are turned on, the electric current flowing through the electromagnet winding 151 (hereinafter referred to as electromagnet current iL) increases, and when both are turned off, the electromagnet current iL decreases.

Also, when one of the transistors 161 and 162 is turned on and the other is turned off, a so-called flywheel current is maintained. Applying flywheel current to the amplifier circuit 150 in this way reduces hysteresis loss at the amplifier circuit 150, and electric power consumption of the overall circuit can be suppressed to a low level. Also, controlling the transistors 161 and 162 in this way enables radio frequency noise such as harmonics and so forth, generated at the turbomolecular pump 100, to be reduced. Further, measuring this flywheel current by the electric current detecting circuit 181 enables the electromagnet electric current iL flowing through the electromagnet winding 151 to be detected.

That is to say, in a case in which the detected electric current value is smaller than the electric current command value, the transistors 161 and 162 are both turned on for an amount of time equivalent to the pulse-width duration Tp1, just one time during the control cycle Ts (e.g., 100 µs), as shown in Fig. 3. Accordingly, the electromagnet electric current iL during this period increases toward an electric current value iLmax (omitted from illustration) that can be caused to flow from the positive terminal 171a to the negative terminal 171b via the transistors 161 and 162.

Conversely, in a case in which the detected electric current value is greater than the electric current command value, the transistors 161 and 162 are both turned off for an amount of time equivalent to the pulse-width duration Tp2, just one time during the control cycle Ts, as shown in Fig. 4. Accordingly, the electromagnet electric current iL during this period decreases toward an electric current value iLmin (omitted from illustration) that can be regenerated from the negative terminal 171b to the positive terminal 171a via the diodes 165 and 166.

In either case, after the pulse-width duration Tp1 or Tp2 elapses, one or the other of the transistors 161 and 162 is turned on. Accordingly, the flywheel current is maintained at the amplifier circuit 150 during this period.

Next, a method of reducing warmup time of the pump, while protecting boards from high temperatures involved with heating, will be described.

First, operations of a temperature control unit of the base portion will be described.

Temperature information is detected from the temperature sensor 3 that is situated near the heater 1, and is input to the control device 200. Note, however, that temperature information may be detected from the unshown temperature sensor situated in the outlet port 133 and so forth, and be input to the control device 200, as well.

The temperature control unit of the base portion is provided in the control device 200. At this temperature control unit of the base portion, operations are started in step 1, as shown in Fig. 5. In step 10, subroutine processing of a warmup state determining unit is performed, and thus transitions to step 2 in Fig. 6. This warmup state determining unit is equivalent to temperature judging means, and all temperature information that is input is compared with a rated temperature in step 3 in Fig. 6. This rated temperature differs depending on the model and specifications of the pump, but is defined as a target temperature necessary to prevent depositing of product matter, and is set to 100 to 150 degrees, for example, during rated operation. Judgment is made of a post-warmup mode when all temperature information that is input is higher than the rated temperature as shown in step 5, and in step 9 the processing returns to the temperature control unit of the base portion. Conversely, when in a state that is lower than the rated temperature, judgment is made of a warmup-underway mode, as shown in step 7, and in step 9 the processing returns to the temperature control unit of the base portion.

Next, in step 13 in Fig. 5, whether the results of the judgment performed in step 3 are post-warmup mode or warmup-underway mode, are read. When judged to be in the warmup-underway mode, the flow advances to step 17, and heating-cooling control is performed. This heating-cooling control can be performed by adaptation of a program for TMS control that is conventionally performed. Accordingly, reconfiguration of the control device 200 can be easily performed in the form of a partial addition of a program. Addition of this program is step 1 to step 9, and steps 13, 15, and 19. Thereafter, operations of step 1 to step 19 are periodically repeated.

A heating-cooling control unit is provided to the control device 200. This heating-cooling control unit is arranged to perform the subroutine processing shown in Fig. 7. When the processing of step 17 is performed, the step transitions to step 21, and in step 23, operation of the water-cooling valve is selected. Thereafter, in step 25, determination is made regarding whether or not a temperature value measured by the temperature sensor 5 that is equivalent to base portion temperature measuring means is no less than a temperature upper limit value for cooling, which is set in advance. For example, this temperature upper limit value for cooling is an upper limit value of a temperature at which the board 143 can be protected.

When the temperature value measured by the temperature sensor 5 is judged to be no lower than the temperature upper limit value for cooling in step 25, the flow advances to step 27 and the water-cooling valve is opened. This temperature upper limit value for cooling is preferably set allowing for leeway, taking into consideration the temperature of the electrical component portions.

Accordingly, performing cooling control on the basis of the temperature of the temperature sensor 5 measure at the base portion 129 around the electrical component portions enables temperature management of the electrical component portions to be performed appropriately. In a case in which the temperature of the semiconductor device exceeds the limit temperature for the semiconductor devices when in the warmup-underway mode, water cooling can be started to perform cooling, and accordingly failure or abnormality of the semiconductor devices due to high temperatures can be prevented, and safety can be realized.

Conversely, when the temperature value measured at the temperature sensor 5 in step 25 is judged to be below the temperature upper limit value for cooling, the flow advances to step 29, and determination is made regarding whether or not the temperature value is no higher than a temperature lower limit value for cooling that is set in advance. When judgment of being no greater than the temperature lower limit value for cooling is made, the flow advances to step 31, and the water-cooling valve is stopped. This temperature lower limit value for cooling is set to a temperature for returning to water-cooling off again. Subsequently, the flow advances to step 33, and thereafter the processing from step 21 to step 33 is periodically repeated. Conversely, in a case in which the temperature value measured at the temperature sensor 5 exceeds the temperature lower limit value for cooling in step 29, the flow advances to step 33.

As an example of when warmup of the pump is being performed, the temperature value measured by the temperature sensor 5 at the time of replacement of the pump is no higher than the temperature lower limit value for cooling, and accordingly the water-cooling valve is stopped, and only heating by the heater 1 is performed, whereby warmup time is reduced. Accordingly, reduction in warmup time can be realized in the warmup-underway mode. Also, in a case in which the limit temperature of the semiconductor devices is exceeded, water cooling can be performed by step 25 and step 27 for cooling, and accordingly safety can be realized.

Next, temperature control of parts other than the base portion by the heating-cooling control unit will be described.

In step 41 in Fig. 8, temperature control of parts other than the base portion by the heating-cooling control unit is started. In step 43, subroutine processing of heating-cooling control is performed, the step transitions to step 21 in Fig. 7, and heater operations are selected in step 23. Thereafter, the flow advances to step 51, and judgment is made regarding whether or not the temperature value measured by the temperature sensor 3 is no less than a temperature upper limit value for heating. In a case of no less than the temperature upper limit value for heating, the heater 1 is then turned off. Conversely, in a case of below the temperature upper limit value for heating, the flow advances to step 55, and judgment is made regarding whether or not the temperature value measured by the temperature sensor 3 is no greater than a temperature lower limit value for heating. In a case of no greater than the temperature lower limit value for heating, the flow then advances to step 57, and the heater 1 is turned on. In a case of exceeding the temperature lower limit value for heating in step 55, the flow advances to step 33.

Thus, high temperature can be maintained at parts other than the base portion, and product matter can be stably prevented from being deposited.

Also, in a case in which the mode read in step 13 in Fig. 5 is the post-warmup mode, the flow advances to step 15 and the water-cooling valve is opened. That is to say, at the point in time of warmup being completed, the water-cooling valve is in a constantly opened state. Thus, the board 143 can be protected from high temperatures involved with heating.

That is to say, in control of the water-cooling valve of the base portion, on and off operations on the basis of the upper limit temperature and the lower limit temperature are performed on the same way as with TMS in the case of warmup-underway mode, and the control is constantly on in the case of post-warmup mode.

Note that when the warmup-underway mode is performed while the rotating body 103 is rotating, the aforementioned frictional heat generated at the time of rotation, and heat generated from the motor 121 can be used, and accordingly the warmup time can be reduced, but the warmup-underway mode may be performed during magnetic levitation with the rotating body 103 stopped.

According to the above, protection of the boards and reduction in warmup time of the pump can be realized while preventing deposition of product matter.

It should be noted that various modifications and combinations of the present invention may be made without departing from the spirit of the present invention, and that such modifications and combinations are encompassed by the present invention, as a matter of course.

- 1: Heater
- 3, 5: Temperature sensor
- 100: Turbomolecular pump
- 102: Rotor blade
- 103: Rotating body
- 104: Upper-side radial-direction electromagnet
- 105: Lower-side radial-direction electromagnet
- 107: Upper-side radial-direction displacement sensor
- 108: Lower-side radial-direction displacement sensor
- 113: Rotor shaft
- 121: Motor
- 122: Stator column
- 127: Outer cylinder
- 129: Base portion
- 149: Water-cooling tube
- 200: Control device

## Claims

1. A vacuum pump, comprising:
a heating unit with a heater situated in at least one location to prevent generation of deposited matter;
a base portion in which a cooling mechanism is situated to prevent a temperature within an electrical component portion from becoming high;
base portion temperature measuring means for measuring temperature of the base portion;
a water-cooling valve for controlling whether or not to perform cooling by the cooling mechanism; and
temperature judging means for judging whether a post-warmup or a warmup is underway, depending on whether the temperatures of all of the heaters of the heating unit exceed a preset temperature, wherein
the water-cooling valve is controlled on the basis of judgment results by the temperature judging means and the temperatures measured by the base portion temperature measuring means.

2. The vacuum pump according to claim 1, wherein cooling by the cooling mechanism is not performed when judgment of warmup-underway is made by the temperature judging means, and the temperature measured by the base portion temperature measuring means is no greater than a temperature lower limit value for cooling.

3. The vacuum pump according to claim 1 or 2, wherein cooling by the cooling mechanism is performed when the temperature measured by the base portion temperature measuring means is no lower than a temperature upper limit value for cooling.

4. The vacuum pump according to claim 3, wherein the temperature upper limit value for cooling is a limit temperature value at which a board situated in the electrical component portion can be protected, or a temperature value set allowing for a certain amount of leeway with respect to the limit temperature value.

5. The vacuum pump according to claim 1 or 2, wherein cooling by the cooling mechanism is performed when judgment of post-warmup is made by the temperature judging means.

6. The vacuum pump according to claim 1 or 2, further comprising:
heating unit temperature measuring means for measuring a temperature of the heating unit, wherein
the set temperature has a temperature lower limit value for heating and a temperature upper limit value for heating, and
heating by the heating unit is performed when the temperature measured by the heating unit temperature measuring means is no greater than the temperature lower limit value for heating, and heating by the heating unit is stopped when the temperature measured by the heating unit temperature measuring means is no lower than the temperature upper limit value for heating.

7. The vacuum pump according to claim 1 or 2, wherein a heating region of the heating unit and a cooling region of the base portion including the electrical component portion are thermally partitioned.

8. A control device of a vacuum pump that includes
a heating unit with a heater situated in at least one place to prevent generation of deposited matter,
a base portion in which a cooling mechanism is situated to prevent temperature within an electrical component portion from becoming high,
base portion temperature measuring means for measuring temperature of the base portion, and
a water-cooling valve for controlling whether or not to perform cooling by the cooling mechanism,
the control device comprising:
temperature judging means for judging whether post-warmup or warmup-underway, in accordance with whether or not temperatures of all of the heaters of the heating unit exceed a set temperature that is set in advance, wherein
the water-cooling valve is controlled on the basis of judgment results by the temperature judging means and the temperatures measured by the base portion temperature measuring means.

9. A control method of warmup time of a vacuum pump that includes
a heating unit with a heater situated in at least one place to prevent generation of deposited matter,
a base portion in which a cooling mechanism is situated to prevent temperature within an electrical component portion from becoming high,
base portion temperature measuring means for measuring temperature of the base portion, and
a water-cooling valve for controlling whether or not to perform cooling by the cooling mechanism,
the control method comprising:
judging whether post-warmup or warmup-underway, in accordance with whether or not temperatures of all of the heaters of the heating unit exceed a set temperature that is set in advance; and
controlling the water-cooling valve on the basis of the temperatures measured by the base portion temperature measuring means, when judgment is made of warmup-underway.
